# EUROPEAN PATENT APPLICATION

(11) **EP 4 788 116 A1**
(43) Date of publication of application: **05.08.2026**
(21) Application number: 26152437.5
(22) Date of filing: 16.01.2026
(51) Int. Cl.: H10W 70/40, H10W 90/00, H10W 70/05, H10W 70/65

(54) **CONNECTING PINS IN A SUBSTRATE**

(30) Priority: 30.01.2025 US 202519041833
(71) Applicant: Shenzhen STS Microelectronics Co., Ltd., Shenzhen 518048 (CN); STMicroelectronics International N.V., 1228 Plan-les-Ouates, Geneva (CH)
(72) Inventor: YOO, Inpil, 82008 Unterhaching (DE); PAUL, Indrajit, 88677 Markdorf (DE); LEUNG, Ho Ting, Shenzhen, 518040 (CN); LIANG, Yi Ming, Shenzhen, 518000 (CN); DING, Feng, Shenzhen, 518000 (CN); FENG, Qing Ming, Shenzhen, 518038 (CN)
(74) Representative: Casalonga

(57) **Abstract**

A packaged device having conductive pillars coupled with a substrate and connecting pins in openings of the conductive pillars. The device further including a molding compound on the substrate and conductive pillars. Methods of coupling connecting pins in the substrate without the use of pinholders. The methods including forming openings in the molding compound and conductive pillars and inserting the pins in the openings of the conductive pillars.

## Description

### BACKGROUND

### Technical Field

The present disclosure relates to a packaged device with connecting pins and methods of forming without the use of pinholders.

### Description of the Related Art

In the automotive industry, electric and hybrid propulsion vehicles have control electronics for an electric motor. The control electronics associated with such vehicles have power modules and signal processing modules. Some exemplary control electronics include power phase inverters and rectifiers capable of operating at very high voltages, up to 1200 V. There are special connection structures, which typically utilize connecting pins, used to electrically couple the modules to each other and to loads, such as, the electric motor or other vehicle members. The connecting pins having larger dimensions compared to the electronic circuits used in other fields.

The modules are normally enclosed in a packaging body of insulating material, such as a molding compound, that encloses the components with electrical connection protruding pins.

The molded power modules are generally arranged on a shaped metal support, called a leadframe, which also forms the pins for both the power connection and the signal connection.

This involves a considerable layout complexity to avoid the presence of parasitic components, typically parasitic inductances, as well as requiring an accurate design to ensure the safety isolation distances ("clearance and creepage") and not allowing an efficient use of available spaces.

To maintain the intricate configurations, it is necessary that the methods of coupling the connecting pins maintain a higher level of accuracy since the positioning is crucial. Known methods employ steps of grinding to expose connection areas and then additional steps of coupling pin holders, such as ultrasonic welding, to ensure the connecting pins are then securely coupled in the desired orientations.

These methods exhibit potential yield loss and are expensive due to the additional steps and material needed. There is also a need for quicker methods of coupling the connecting pins.

### BRIEF SUMMARY

An aspect of the disclosure relates to a method of coupling connecting pins with a packaged device without the use of pinholders. The packaged device includes a substrate having conductive pillars that are coupled with the connecting pins and a molding compound on the substrate. The method includes forming recesses in the conductive pillars and coupling the pins in the formed recesses so that inner surfaces of the conductive pillars are in direct contact with the pins.

In particular, an aspect of the disclosure relates to a method, comprising:
obtaining a conductive pillar and a substrate, the conductive pillar having a first surface opposite a second surface, the first surface of the conductive pillar being coupled to a first surface of the substrate;
forming a molding compound on the conductive pillar and the first surface of the substrate;
forming a recess (or an opening) in the second surface of the conductive pillar; and
coupling a connecting pin to the substrate by inserting the connecting pin in the recess of the conductive pillar.

In one or more embodiments, the forming of the recess may be carried out via drilling.

In particular, the drilling may include drilling through the molding compound.

In one or more embodiments, the coupling of the connecting pin may be carried out via press-fit insertion.

In one or more embodiments, the connecting pin may extend through the molding compound.

In one or more embodiments, the molding compound may entirely cover the first surface of the substrate and the conductive pillar.

In one or more embodiments, the method may further comprise:
forming a through opening in the molding compound to remove the molding compound from the second surface of the conductive pillar; and
forming the recess through the through opening.

In one or more embodiments, the molding compound may partially cover the conductive pillar, the first surface of the conductive pillar being covered by the molding compound, at least part of the second surface of the conductive pillar not being covered by the molding compound.

In one or more embodiments, the recess may have a bottom surface in the conductive pillar.

In one or more embodiments, the method may further comprise:
obtaining at least one other conductive pillar, each conductive pillar of the at least one other conductive pillar having a first surface opposite a second surface, the first surface of each conductive pillar of the at least one other conductive pillar being coupled to the first surface of the substrate, the molding compound being further formed on the at least one other conductive pillar;
forming at least one other recess, each recess among the at least one other recess being formed in the second surface of a respective conductive pillar among the at least one other conductive pillar; and
coupling at least one other connecting pin to the substrate by inserting each connecting pin of the at least one other connecting pin in a respective recess among the at least one other recess.

In one or more embodiments, the molding compound may entirely cover the first surface of the conductive pillar and the first surface of each conductive pillar among the at least one other conductive pillar.

In alternative embodiments, the molding compound may partially cover the conductive pillars, the first surfaces of the conductive pillars being exposed from the molding compound.

In one or more embodiments, the substrate may include ceramic and copper.

In particular, the substrate may be an active metal brazing (AMB) substrate.

Another aspect of the disclosure relates to a device, comprising:
a substrate having a first surface;
conductive pillars, each of the conductive pillar having a respective first surface coupled to the first surface of the substrate;
a molding compound on the first surface of the substrate and the conductive pillars;
recesses (or openings) in the molding compound and the conductive pillars; and
connecting pins coupled to the substrate, each connecting pin being located in a respective recess among the recesses.

In one or more embodiments, the connecting pins may have side surfaces contacting inner surfaces of the conductive pillars.

In one or more embodiments, portions of the connecting pins may be recessed from the first surfaces of the conductive pillars.

In one or more embodiments, the device may comprise gaps in the conductive pillars, each gap being between the substrate and a respective connecting pin among the connecting pins.

In one or more embodiments, the molding compound may cover the first surfaces of the conductive pillars.

In one or more embodiments, the molding compound may contact the connecting pins and the conductive pillars.

In one or more embodiments, the conductive pillars may extend along a first direction from the substrate, and the connecting pins may extend along the first direction from the conductive pillars through the molding compound.

Another method is provided, comprising forming a plurality of recesses in a plurality of conductive pillars, each recess of the plurality of recesses is in a first surface of a respective conductive pillar of the plurality of conductive pillars, each conductive pillar has a second surface opposite the first surface, the second surface coupled to a first surface of a substrate having a molding compound over the substrate, and coupling a plurality of pins to the substrate, each pin of the plurality of pins being in a respective recess of the conductive pillar.

In this method, the substrate may include ceramic and copper. For example, the substrate may be an active metal brazing (AMB) substrate.

In this method, the molding compound may entirely cover the first surfaces of plurality of conductive pillars.

In this method, the molding compound may partially cover the conductive pillars, the first surfaces of the conductive pillars may be exposed from the molding compound.

In this method, the molding compound may entirely cover the first surface of the substrate.

### BRIEF DESCRIPTION OF THE DRAWINGS

Fig. 1 is a perspective view of a packaged device coupled with connecting pins according to an embodiment.
Figs. 2A-2D are steps of manufacturing the packaged device of Fig. 1.
Fig. 3 is a cross-section view of another embodiment of the packaged device.

### DETAILED DESCRIPTION

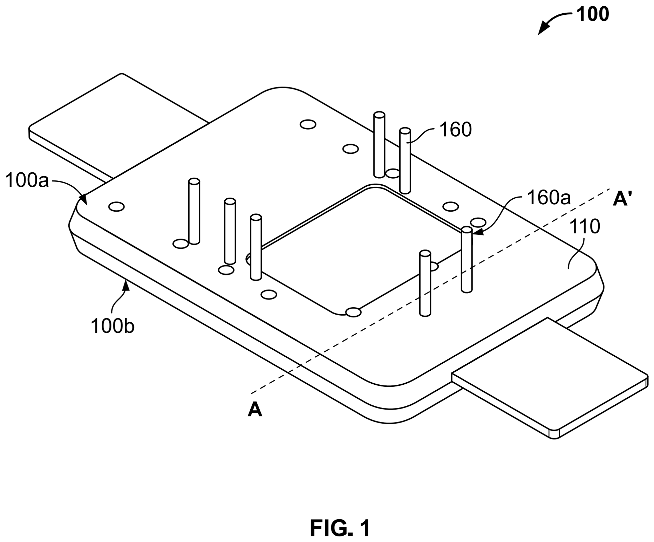

Fig. 1 is a packaged device 100 coupled with connecting pins 160. The packaged device 100 includes a substrate covered by an outer molding compound or packaging mass 110. The connecting pins 160 extend from conductive pillars coupled with the substrate through the molding compound 110 along a first or vertical direction.

The packaged device 100 has a substantially rectangular shape including a top surface or side 100a opposite a bottom surface or side 100b. The connecting pins 160 extending through the top surface of the device 100a. The connecting pins 160 having an end 160a outside of the packaged device 100.

The connecting pins 160 are spaced from outer edges of the packaged device 100. The pins 160 may be arranged along a similar shape as a perimeter of the packaged device 100. Each pin 160 is spaced from each other. The connecting pins 160 are in direct contact with the molding compound 110.

The molding compound 110 is an insulating layer. The molding compound 110 may be made of an epoxy molding compound (EMC) or other suitable insulating material. The insulating material may be molded resin such as a molding compound, an encapsulant, an epoxy, or other suitable insulating material.

In some embodiments, the packaged device 100 is a power module.

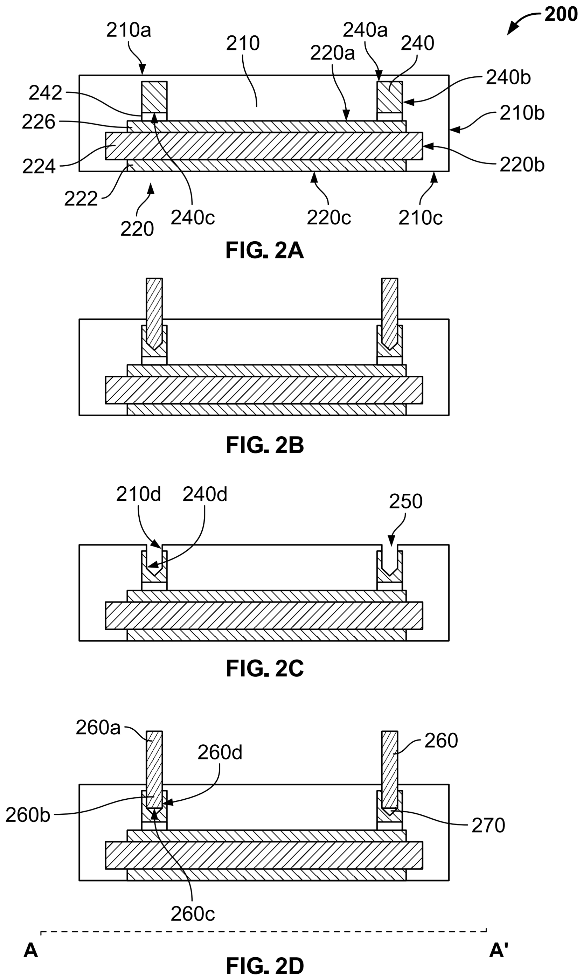

Figs. 2A-2D are steps of manufacturing the packaged device 100 with connecting pins 160 of Fig. 1.

Conductive pillars 240 are coupled with a top surface of a substrate 220a. Then, the molding compound 210 is formed on the conductive pillars 240 and the substrate 220. In some embodiments, the molding compound 210 is formed by depositing a layer of molding compound on the substrate 220. In other embodiments, the molding compound 210 is formed using a mold.

Fig. 2A is a cross-section view of the packaged device 200 including the molding compound or insulating layer 210 on the substrate 220 and conductive pillars 240.

The substrate 220 may be a semiconductor substrate or may include one or more semiconductor materials.

In this embodiment, the substrate 220 is a multilayer substrate having multiple sublayers. The multilayer substrate is a Direct Bonded Copper (DBC) substrate, Active Metal Brazing (AMB) substrate, or other suitable multilayer substrate.

The substrate 220 includes an insulating layer 224 between first and second conductive layers 222, 226. The conductive layers 222, 226 are made of a suitable conductive metal such as copper. Whereas the insulating layer 224 is made of a suitable insulating material such as ceramic.

The first conductive layer 222 is the bottom conductive layer of the substrate 220 and includes the bottom surface of substrate 220c. The second conductive layer 226 is the top conductive layer and includes the top surface of the substrate 220a.

The substrate 220 extends along the first direction to the conductive pillars 240. The substrate 220 extends along a second or horizontal direction, transverse the first direction.

In this embodiment, the insulating layer 224 has a first thickness or dimension in the second direction that is greater than a first thickness or dimension in the second direction of the conductive layers 222, 226. In other words, the insulating layer 224 protrudes past side surfaces of the conductive layers 222, 226.

In some embodiments, electronic components are coupled with and on the substrate 220. The electronic components may be power components such as diodes, transistors, thyristors or IGBTs, or packaged discrete components.

A plurality of conductive pillars 240 are coupled to the top surface of the substrate 220a. The conductive pillars 240 are spaced from each other. The molding compound 210 encompassing or covering the pillars 240. The pillars 240 have a cylindrical shape or other suitable shape with a circular base and extends from the substrate 220.

In some embodiments, the pillars 240 are soldered or glued to the substrate 220 through bonding material 242 such as a filler material, conductive glue, adhesive or other suitable adhesive material. The bonding material 242 is between the substrate 220 and the conductive pillars 240. The molding compound 210 contacting the bonding material 242.

The pillars 240 have dimensions generally linked to dimensions of the device 200. In some embodiments, the pillars 240 have a height comprised between 2 and 7 mm (millimeters), in particular, about 4.5 mm, and a diameter comprised between 1 and 5 mm, for example of about 2 mm.

The top surfaces of the pillars 240a are substantially flat for coupling to other components. In this embodiment, the pillars 240 have similar heights and dimensions relative to each other. In other embodiments, the pillars 240 have differing heights and dimensions relative to each other.

The pillars 240 are arranged in any suitable configuration. In some embodiments, there are pillars 240 arranged adjacent to edges of the substrate 220. In other words, a central region of the substrate 220 does not include any pillars 240. In at least one embodiment, there are eight pillars 240 with two pillars 240 spaced from a first edge or side of the substrate whereas six pillars 140 are arranged along a second edge or side transverse the first edge.

The pillars 240 are made of a conductive material like copper or other suitable conductive material.

In some embodiments, the pillars 240 are made of the same material as the conductive layer of the substrate 226.

In other embodiments, the pillars 240 are made of different material than the conductive layer 226.

The molding compound 210 extends on the top surface of the substrate 220a and covers the conductive pillars 240. A top surface of the molding compound 210a being spaced from top surfaces of the conductive pillars 240a. The molding compound 210 is on the top and side surfaces of the conductive pillars 240a,240b and the substrate 220a,220b. Side surfaces of the molding compound 210b are spaced from side surfaces of the substrate 220b and conductive pillars 240b. Bottom surfaces of the molding compound 210c are adjacent to a bottom surface of the substrate 220c.

In this embodiment, the top surface of the molding compound 210a is substantially uniform and coplanar throughout. In other embodiments, the top surface of the molding compound 210a is warped or deformed and not uniformly flat or coplanar. In other words, the thickness of the molding compound 210 varies over the pillars 240.

Next, through openings are formed in the molding compound 210 that is on the conductive pillars 240. Forming the through openings exposes top surfaces of the conductive pillars 240.

Then, openings or recesses 250 are formed in the conductive pillars 240, as shown in Figs. 2B and 2C.

Fig. 2B is a step of forming a plurality of recesses or holes 250 in the conductive pillars 240. As a result, drilled pillars are formed in Fig. 2C. Each conductive pillar 240 has a respective recess 250 as shown in Fig. 2C.

Forming the recesses 250 is carried out through the top of the molding compound 210a to the pillars 240. Portions of the pillars 240 and molding compound 210 are removed in the step of forming the recesses 250.

In some embodiments, the plurality of recesses 250 are formed simultaneously at the same time. In other embodiments, the plurality of recesses 250 are formed individually or sequentially.

Inner surfaces of the pillars 240d and inner side surfaces of the molding compound 210d are thereby exposed. The inner surfaces of the pillars 240d and the inner side surfaces of the molding compound 210d are substantially coplanar. The inner side surfaces of the molding compound 210d are transverse to the top surface of the molding compound 210a. Portions of the molding compound 210 protrude or extend on the top surfaces of the pillars 240a.

The recesses 250 are formed in the tops of the pillars 240 and do not extend past bottom surfaces of the pillars 240c to the substrate 220. The recesses 250 are delimited by the pillars 240 and molding compound 210. Each recess 250 is delimited by inner surfaces of the pillars 240d. Said differently, the recesses 250 are not in the substrate 220.

The recesses 250 are positioned to be centrally in the pillars 240. The recesses 250 can be positioned as desired within the pillars 240.

The recesses 250 have a width or first dimension between the side surfaces of the pillars 240b and a depth or second dimension from the top surfaces of the pillars 240a.

The recesses 250 are formed with a degree of tolerance that permits proper fitting or receiving of the pins 260 without causing damage. The dimensions of the recesses 250 permit interference fit with the pin 260.

In this embodiment, the width of the recess is less than the depth of the recess. In other embodiments, the size and shape of the recess is determined by the size and shape of the respective connecting pin to be used.

In this embodiment, precision drilling is used to form the recesses 250. A drill predrills the recesses 250. In other embodiments, other suitable methods for etching the recesses 250 are utilized.

A clamp, or other suitable securing mechanism, is used during this step of forming the recesses to prevent displacement or movement of the packaged device 200. This helps ensure the intended positioning and sizing of the recesses is obtained.

After the recesses 250 are formed, the recesses 250 are cleaned in some embodiments to remove debris and prepare for the next step of attaching the connecting pins 260.

Next, the connecting pins 260 are coupled with the substrate 220 via the conductive pillars 240 as shown in Fig. 2D. Fig. 2D is a cross-section from line A-A' of Fig. 1.

The pins 260 are solid cylindrical, tubular, or other suitable shape for attaching to other components. The pins 260 have a height higher than or equal to that of the pillar 240.

In this embodiment, the pins 260 are press-fit pins. In other embodiments, the pins 260 are straight solder pins or other suitable connecting pins.

In other embodiments, compliant pins or other suitable pins are used.

The pins 260 have a first free end 260a opposite a second end 260b. The second end 260b is in the recess 250 of the pillar 240. A bottom surface of the pin 260c, of the second end 260b, is spaced from the bottom surface of the pillar 240c. Side surfaces 260d of the pin 260 are coupled with the inner side surfaces of the pillar 240d.

The pin 260 extends from the pillar 240 through the molding compound 210. The first end of the pin 260a being exposed from the molding compound 210 and the pillar 240. The first end of the pin 260a configured to couple with other components.

Side surfaces of the pin 260d contact the inner side surfaces of the molding compound 210d. In some embodiments, the surfaces are coplanar.

The pins 260 allow a current to flow and are made of copper or other suitable conductive material. In some embodiments, the pins 260 are copper nickel plated.

In some embodiments, the pins 260 include base portions that are differently shaped or sized than the main pole portion of the pins 260. In at least one embodiment, the base portion is a substantially square or rectangular.

In some embodiments, the pins 260 have one or more enlarged press-fit-type pin contact zones.

In some embodiments, the pins 260 have stop zones or blocking elements.

In other embodiments, the pins 260 are rod-shaped elements. In these embodiments, some pins 260 have a base wider than the rod-shaped portion.

The pins 260 are inserted in the recesses 250 and coupled with the conductive pillars 240. In some embodiments, the pin 260 are attached via press-fit insertion where force is applied to utilize the press-fit technique. In some embodiments, a press-fit pin assembly is used to insert the pins 260 into the pillars 240.

In other embodiments, other solderless coupling methods are used to attach the pins 260.

In this embodiment, an air gap or bubble 270 is formed below the pin 260 and in the pillar 240. The air gap 270 is between the pin 260 and the bottom surface of the pillar 240c. The air gap 270 is between side surfaces of the pillar 240b.

In some embodiments, the pins 260 are soldered or glued to the pillars 240. Bonding material is provided between the pins 260 and the pillars 240. The bonding material is soldering filler material, a conductive glue, or other suitable adhesive material.

In other embodiments, the pins 260 are soldered without filler material by ultrasonic welding or other suitable methods.

In other embodiments, there is no air gap 270. In some embodiments, the pin 260, adhesive material, or a combination thereof, entirely fills in the recess 250.

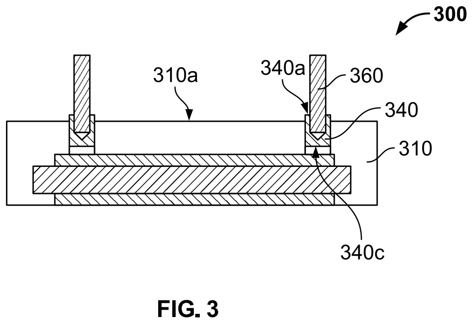

Fig. 3 is another embodiment of the packaged device 300 coupled with pins 360. In this embodiment, the packaged device 300 is formed using the same steps as described for Figs. 2A-2D except the top surface of the molding compound 310a is recessed below the top surface of the pillars 340a.

As in Fig. 2A, a packaged device 300 is provided as a first step. The package device 300 including a molding compound 310 over the substrate having pillars 340.

In this embodiment, the molding compound 310 is not entirely over the pillars 340. Instead, the top surfaces of the pillars 340a are exposed from the molding compound 310. Only side surfaces of the pillars 340 contact the molding compound 310.

As a result, in this embodiment, the step of forming of the recesses, as described in Figs. 2B and 2C, does not include removing portions of the molding compound 310.

In this embodiment, the molding compound 310 does not contact the pins 360. The pins 360 are only in direct contact with the pillars 340. The top surface of the molding compound 310a is recessed from the first end of the pins 360 and the top surfaces of the pillars 340a.

In other embodiments, the top surface of the molding compound is coplanar with top surfaces of the pillars.

The packaged devices 100, 200, 300 are used in components for electric and hybrid vehicles, such as traction inverters, DC-DC converters, onboard charging, and other applicable semiconductor components.

The packaged devices 100, 200, 300 are Silicon Carbide (SiC) and Gallium Nitride (GaN) compatible.

The various embodiments described above can be combined to provide further embodiments. Aspects of the embodiments can be modified, if necessary to employ concepts of the various patents, applications and publications to provide yet further embodiments.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A method, comprising:
obtaining a conductive pillar (240, 340) and a substrate (220), the conductive pillar (240, 340) having a first surface (240c, 340c) opposite a second surface (240a, 340a), the first surface (240c, 340c) of the conductive pillar (240, 340) being coupled to a first surface (220a) of the substrate (220);
forming a molding compound (110, 210, 310) on the conductive pillar (240, 340) and the first surface (220a) of the substrate (220);
forming a recess (250) in the second surface (240a, 340a) of the conductive pillar (240, 340);
and
coupling a connecting pin (160, 260, 360) to the substrate by inserting the connecting pin (160, 260, 360) in the recess (250) of the conductive pillar (240, 340).

2. The method of claim 1, wherein the forming of the recess (250) is carried out via drilling.

3. The method of any one of the preceding claims, wherein the coupling of the connecting pin (160, 260, 360) is carried out via press-fit insertion.

4. The method of any one of the preceding claims, wherein the connecting pin (160, 260) extends through the molding compound (110, 210).

5. The method of any one of the preceding claims, wherein the recess (250) has a bottom surface in the conductive pillar (240, 340).

6. The method of any one of the preceding claims, comprising:
obtaining at least one other conductive pillar (240, 340), each conductive pillar (240, 340) of the at least one other conductive pillar (240, 340) having a first surface (240c, 340c) opposite a second surface (240a, 340a), the first surface (240c, 340c) of each conductive pillar (240, 340) of the at least one other conductive pillar (240, 340) being coupled to the first surface (220a) of the substrate (220), the molding compound (110, 210, 310) being further formed on the at least one other conductive pillar (240, 340);
forming at least one other recess (250), each recess (250) among the at least one other recess (250) being formed in the second surface (240a, 340a) of a respective conductive pillar (240, 340) among the at least one other conductive pillar (240, 340); and
coupling at least one other connecting pin (160, 260, 360) to the substrate by inserting each connecting pin of the at least one other connecting pin in a respective recess (250) among the at least one other recess (250).

7. The method of claim 6, wherein the molding compound (110, 210, 310) entirely covers the first surface of the conductive pillar and the first surface of each conductive pillar among the at least one other conductive pillar.

8. The method of claim 6, wherein the molding compound partially covers the conductive pillars, the first surfaces of the conductive pillars being exposed from the molding compound.

9. The method of any one of the preceding claims, wherein the substrate (220) includes ceramic and copper.

10. A device, comprising:
a substrate (220) having a first surface (240a);
conductive pillars (240, 340), each of the conductive pillar (240, 340) having a respective first surface (240c, 340c) coupled to the first surface (220a) of the substrate (220);
a molding compound (110, 210, 310) on the first surface (220a) of the substrate (220) and the conductive pillars (240, 340);
recesses (250) in the molding compound and the conductive pillars (240, 340); and
connecting pins (160, 260, 360) coupled to the substrate (220), each connecting pin (160, 260, 360) being located in a respective recess (250) among the recesses.

11. The device of claim 10, wherein the connecting pins (160, 260, 360) have side surfaces contacting inner surfaces of the conductive pillars.

12. The device of claim 10 or 11, wherein portions of the connecting pins (160, 260, 360) are recessed from the first surfaces (240c, 340c) of the conductive pillars (240, 340).

13. The device of any one of claims 10 to 12, comprising gaps (270) in the conductive pillars (240, 340), each gap (270) being between the substrate (220) and a respective connecting pin among the connecting pins (160, 260, 360).

14. The device of any one of claims 10 to 13, wherein the molding compound (110, 210, 310) covers the first surfaces (240c, 340c) of the conductive pillars (240, 340).

15. The device of any one of claims 10 to 14, wherein the molding compound (110, 210, 310) contacts the connecting pins (160, 260, 360) and the conductive pillars (240, 340).

16. The device of any one of claims 10 to 15, wherein the conductive pillars extend along a first direction from the substrate, and wherein the connecting pins (160, 260, 360) extend along the first direction from the conductive pillars (240, 340) through the molding compound (110, 210, 310).
